# EUROPEAN PATENT APPLICATION

(11) **EP 0 634 779 A1**
(43) Date of publication of application: **18.01.1995**
(21) Application number: 94302899.3
(22) Date of filing: 22.04.1994
(51) Int. Cl.: H01J 37/34, H01J 37/32, C23C 14/50

(54) **Collimation chamber with rotatable pedestal**

(30) Priority: 11.06.1993 US 75270
(71) Applicant: APPLIED MATERIALS, INC., Santa Clara California 95054-3299 (US)
(72) Inventor: Tepman, Avi, Cupertino, CA 95014 (US)
(74) Representative: Bayliss, Geoffrey Cyril

(57) **Abstract**

A collimation chamber (6) for use in physical vapor deposition of a wafer includes a device (5) for rotating a wafer (4) inside the collimation chamber during a deposition process. The device for rotating a wafer comprises a rotatable pedestal (5) which is positioned at the bottom of the collimation chamber. The means for depositing comprises a target (2) positioned above the rotatable pedestal. A collimator (3) is positioned between the target and the wafer. Two or more elements can also be reactively combined inside of the collimation chamber to be deposited on the surface of the wafer. A method for depositing deposition material over the surface of a wafer inside of a collimation chamber comprises the steps of rotating the wafer inside the collimation chamber and depositing a deposition marterial over the surface of a wafer while it is being rotated inside of the collimation chamber. The step of rotating the wafer inside the collimation chamber is accomplished by rotating a pedestal (5) which the wafer (4) is positioned on, the pedestal positioned at the bottom of the collimation chamber. The deposition material is deposited over the surface of the wafer by bombarding a target (3) with particles causing pieces of the target to be sputtered and deposited on the surface of the wafer. Reactive sputtering can also be accomplished by introducing gas particles of an element into the collimation chamber, the gas particles to react with the discharged particles from the target and form a reactive compound to be deposited on the surface of the wafer. The ions used to bombard the target are attracted towards the target by applying an appropriate voltage to the target. The method further comprises the step of collimating the discharged pieces from the target on their way to be deposited on the wafer.

## Description

The present invention relates to the field of physical vapor deposition of wafers. More specifically, the present invention relates to the field of physical vapor deposition of wafers in a deposition chamber having a collimator.

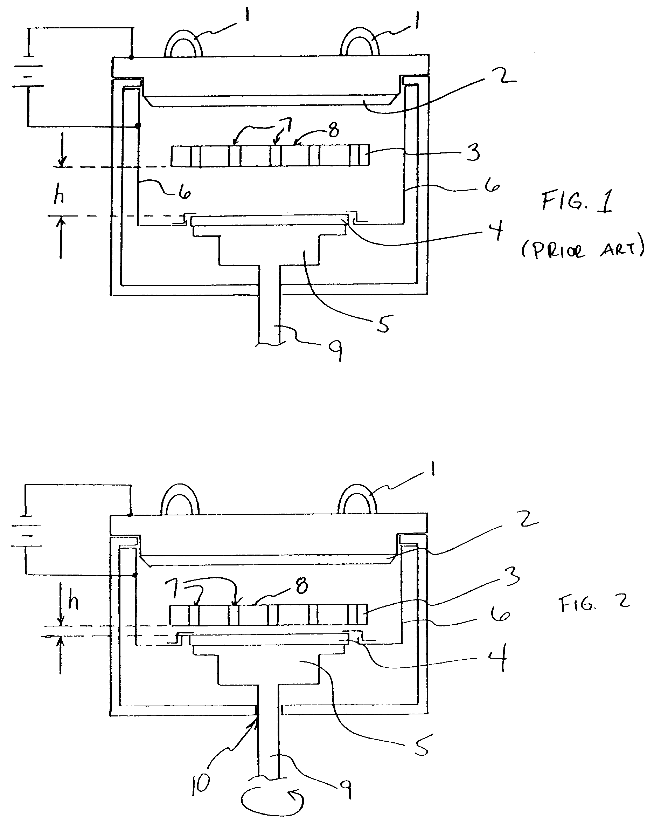

During the physical vapor deposition of wafers, a deposition chamber, as illustrated in Figure 1, is used to sputter the deposition material on a wafer 4. This deposition material can be any compound which is commonly used in the physical vapor deposition of wafers. Aluminum, an Aluminum alloy, Titanium, Tungsten and a compound of Titanium and Tungsten are commonly used as deposition materials. A target 2 is formed out of the deposition material to be used and is positioned at the top of the collimation chamber 6. The wafer 4 is supported by a pedestal 5 and is positioned at the bottom of the collimation chamber 6.

During the deposition process the chamber is evacuated and provided a partial pressure of a gas, e.g., Argon. As is well known, a plasma of the gas is formed in the chamber. Ions from the plasma are attracted to the target by applying an appropriate voltage to the target. For example, a plasma can be formed by applying a sufficiently large DC voltage between the target 2 and the shields 6. By applying the negative terminal of the voltage supply to the target 2, the ions in the plasma will be attracted to the target 2 as the plasma is formed.

As the plasma ions strike the target 2, particles are sputtered from the surface of the target 2 at a significant kinetic energy. Because of the amount of kinetic energy imparted to the particles escaping from the target 2, the particles will typically adhere securely to any solid structure which they strike including the interior surface of the shield 6.

A magnetron 1 can be used to shape the plasma and the flow of ions to the target 2. A magnetron 1 can be one or more permanent magnets or electro-magnets of appropriate strength, orientation and position to achieve the desired shaping.

In this deposition chamber it is also possible to conduct reactive sputtering using more than one element to make up the deposition material. To conduct reactive sputtering and deposit a compound consisting of more than one element on the wafer 4, a gas of the second element is introduced into the deposition chamber inside the area enclosed by the shield 6. The first element is still obtained from the target 2 as described above. As the sputtered particles from the target 2 are travelling away from the target 2, they react with the gas particles on their way to the wafer 4 forming a reactive compound which is then deposited on the wafer 4.

A collimator 3 is positioned between the target 2 and the wafer 4 inside of the collimation chamber 6 to allow only particles travelling within a predetermined range of angles to strike the wafer. The collimator 3 has holes 7 which extend throughout its depth, allowing the a portion of the particles sputtered from the target 2 to pass through the collimator 3 if they are projected through a hole 7. During a deposition cycle some of the particles sputtered from the target 2 travel through the holes 7 and are deposited on the wafer 4.

Inside the collimation chamber 6, the wafer 4 rests on a pedestal 5 which is positioned at the bottom of the collimation chamber 6. If the wafer 4 is positioned too closely to the collimator 3, a pattern of the target material corresponding to the holes 7 in the collimator will be deposited onto the wafer 4. Because of the range of angles of target material the collimator 3 passes, as the wafer 4 and collimator 3 are separated the deposited pattern for each hole 7 expands. As the distance is increased further the patterns will merge into a uniform coverage of target material onto the wafer 4. In order to get an even deposition of material on the surface of the wafer 4 it is necessary to place the wafer a significant distance below the collimator 3 in a prior art chamber. This distance between the wafer 4 and the collimator 3 will be referred to as the height h of the collimator and is also illustrated in Figure 1.

The ratio of the depth of the holes 7 to the diameter of the holes 7 is called the aspect ratio. The aspect ratio of the holes through the collimator 3 has a direct relationship to the range of angles the particles can pass through the collimator 3 thereby defining the size of the pattern of the deposited material on the wafer corresponding to the holes and therefore height h necessary for a uniform deposition. If the aspect ratio of the collimator 3 is increased, the height h of the collimator 3 must also be increased to provide a uniform deposition of material on the surface of the wafer 4. A typical height h in this type of collimation chamber 6 is approximately 50 mm.

A portion of the particles of target material will strike a gas molecule and ricochet to strike the bottom of the collimator 3. Such particles have low kinetic energy and this causes poor adhesion. As such, this material will readily flake off of the bottom of the collimators onto the wafer 4. The longer the distance h, the more likely a particle will strike a gas molecule.

In this collimation chamber 6 it is also possible to conduct reactive sputtering using more than one element to make up the deposition material. To conduct reactive sputtering and deposit a compound consisting of more than one element on the wafer 4, a gas of the second element is introduced into the collimation chamber 6. The first element is still obtained from the target 2 as described above. As the discharged particles from the target 2 are travelling away from the target 2, they react with the gas particles on their way to the wafer 4, forming a reactive compound which is then deposited on the wafer 4. Reactive sputtering increases the likelihood that particles of target material will ricochet onto the bottom of the collimator 3.

During the reactive sputtering, the gas particles from the second element are also deposited on the bottom of the collimator 3 and on the target 2 as a loose material with a low kinetic energy. Some percentage of the target particles will reflect off gas molecules back to the target 2 and the bottom of the collimator 3, with little or no energy. This poor adhesion deposition on the bottom of the collimator 3 will cause the holes 7 to become clogged and will require the collimator 3 to be replaced periodically.

Further, the larger the height h of the collimator 3, the more power that is required to operate the collimation chamber 6. Because it is a farther distance from the target 2 to the wafer 4, the discharged particles must be discharged from the target with more energy to enable them to reach the wafer's surface.

Different size collimation chambers are also needed for collimators with different aspect ratios. The height h of the collimator 3 above the wafer 4 is dependent on the aspect ratio of the collimator 3 and therefore the size of the collimation chamber 6 needed is also dependent on the aspect ratio of the collimator 3. The bigger the aspect ratio of the collimator 3 to be used the bigger the collimation chamber 6 needed for deposition.

What is needed is a system which allows the wafer 4 to be placed close to the collimator 3 but also deposits a uniform layer of deposition material over the surface of the wafer.

A collimation chamber for use in physical vapor deposition of a wafer includes a device for rotating a wafer inside the collimation chamber during a deposition process. The device for rotating a wafer comprises a rotatable pedestal which is positioned at the bottom of the collimation chamber. The means for depositing comprises a target positioned above the rotatable pedestal. A collimator is positioned between the target and the wafer. Two or more elements can also be reactively combined inside of the collimation chamber to be deposited on the surface of the wafer.

A method for depositing deposition material over the surface of a wafer inside of a collimation chamber comprises the steps of rotating the wafer inside the collimation chamber and depositing a deposition material over the surface of a wafer while it is being rotated inside of the collimation chamber. The step of rotating the wafer inside the collimation chamber is accomplished by rotating a pedestal which the wafer is positioned on, the pedestal positioned at the bottom of the collimation chamber. The deposition material is deposited over the surface of the wafer by bombarding a target with particles causing pieces of the target to be sputtered and deposited on the surface of the wafer. Reactive sputtering can also be accomplished by introducing gas particles of an element into the collimation chamber, the gas particles to react with the discharged particles from the target and form a reactive compound to be deposited on the surface of the wafer. The ions used to bombard the target are attracted towards the target by applying an appropriate voltage to the target. The method further comprises the step of collimating the discharged pieces from the target on their way to be deposited on the wafer.

The following is a description of a specific embodiment of the present invention, reference being made to the accompanying drawings, in which
Figure 1 illustrates a collimation chamber of the prior art.
Figure 2 illustrates a collimation chamber of the present invention with rotatable pedestal.

A collimation chamber of the present invention is illustrated in Figure 2. Like reference numerals are used to represent elements common to both the invention of Figure 2 and the prior art of Figure 1. The height h between the collimator 3 and the wafer 4 is greatly decreased from the collimation chamber as illustrated in Figure 1. The pedestal 5 is positioned close to the collimator 3. The pedestal 5 and the collimator 3 are rotated relative to one another. In the preferred embodiment, the pedestal 5 is rotated to spin the wafer 4 during deposition.

The pedestal 5 and the wafer 4 are preferably rotated at a constant rate during the collimation process allowing the collimator 3 to be positioned close to the wafer 4 while still depositing a uniform layer of deposition material over the wafer's surface. The pedestal 5 is mounted to a column 9 which is journalled to a bearing 10. The column 9 is rotated by a motor (not shown). Because the bottom of the target and the surface of the wafer are both essentially flat, the only limitation on the closeness between the target is the thickness of the layer being deposited onto the wafer. Indeed, by rotating the wafer 4 during deposition, the height h can be decreased to approximately 1 millimeter. The pedestal can be spun at any convenient rate.

The collimator of the present invention will not require replacement as often, because there are fewer gas particles in the smaller volume of space between the collimator 3 and the wafer 4. As such, there are necessarily less particles of target material that can ricochet back and be deposited with poor adhesion to the bottom of the collimator 3.

Reactive sputtering can also be conducted in this collimation chamber. During reactive sputtering, because the wafer 4 is positioned closer to the collimator 3, fewer gas particles can be hit by a particle to cause particles to ricochet and be deposited on the bottom of the collimator 3.

The height h of the collimator 3 is not dependent on the aspect ratio of the collimator 3 in the collimation chamber 6 of Figure 2. Rather, the placement of the holes in the collimator is selected relative to the axis of rotation of the pedestal so that all portions of the wafer are uniformly located directly under a hole for an equivalent amount of time thereby providing uniform deposition coverage. In the collimation chamber 6 of the present invention, the height h can remain constant, independent of the aspect ratio, and a uniform layer of deposition material will be deposited on the wafer 4. Because the height h is independent of the aspect ratio, the same size collimation chamber 6 can be used for all collimators 3, regardless of their aspect ratio.

The size of the target 2 and the collimator 3 can also both be reduced because the wafer 4 is positioned closer to both the target 2 and the collimator 3. Because a smaller target 2 can be used there will be less buildup of deposition material on the interior surface of the collimation chamber 6 and the efficiency of the collimation chamber 6 will thereby be increased. Less power will be required because the wafer 4 is positioned closer to the target 2 and the discharged particles will need less energy to reach the surface of the wafer 4.

It will be apparent to one of ordinary skill in the art that various modifications may be made to the preferred embodiment without departing from the spirit and scope of the invention as defined by the appended claims. For example, though circular rotation of the pedestal is described, it is possible to use orbital rotation. Such rotation may provide more uniform coverage with certain placement of holes in the collimator. Another variation, is to rotate the collimator and leave the wafer stable or to rotate both the collimator and the wafer relative to one another.

## Claims

1. A collimation chamber for use in physical vapor deposition of a material onto a wafer, the chamber including a target, a pedestal for supporting a wafer and a collimator positioned between the target and the wafer and further comprising means for rotating the wafer and the collimator relative to one another.

2. The collimation chamber according to claim 1 wherein the means for rotating comprises of a rotatable pedestal positioned to hold the wafer at the bottom of the collimation chamber.

3. The collimation chamber according to claim 1 or claim 2 wherein the collimator is positioned no higher than one millimeter above the wafer.

4. A method of depositing material from a target onto a surface of a wafer inside of a deposition chamber having a collimator comprising the steps of:
a. rotating the wafer and the collimator relative to one another inside a collimation chamber; and
b. depositing the target material over a surface of the wafer.

5. The method according to claim 4 wherein the step of rotating is accomplished by rotating a pedestal on which the wafer is positioned.

6. The method according to claim 4 or claim 5 wherein the collimator and the wafer are less than one millimeter apart.

7. The method according to any of claims 4 to 6 wherein the target material is deposited over the surface of the wafer by bombarding the target with ions causing particles of the target to be sputtered and deposited on the surface of the wafer.

8. The method according to any of claims 4 to 7 further comprising the step of introducing a gas into the deposition chamber, the gas to react with the discharged particles from the target and form a reactive compound for deposition onto the surface of the wafer.

9. A deposition chamber for use in physical vapor deposition of a deposition material onto a wafer, the wafer having a surface, comprising:
a. a rotatable pedestal for supporting a substantially planar wafer positioned at the bottom of the collimation chamber;
b. a target comprising the deposition material positioned above the rotatable pedestal;
c. A substantially planar collimator positioned between the target and the wafer; and
d. means for sputtering deposition material from the target onto the wafer.

10. The collimation chamber according to claim 9 wherein the collimator is positioned no higher than one millimeter above the wafer supported by the pedestal.

11. The collimation chamber accordingly to claim 9 or claim 10 further comprising means for introducing a gas into the chamber and reactively combining the gas with the deposition material.

12. A collimation chamber for use in physical vapor deposition of a material onto a wafer, the chamber including a target, a pedestal for supporting a wafer and a collimator positioned between the target and the wafer and further comprising means for rotating the wafer during a deposition process.

13. A collimation chamber for use in physical vapor deposition of a material onto a wafer, the chamber including a target, a pedestal for supporting a wafer and a collimator positioned between the target and the wafer and further comprising means for rotating the collimator during a deposition process.
